# EUROPEAN PATENT APPLICATION

(11) **EP 4 387 406 A1**
(43) Date of publication of application: **19.06.2024**
(21) Application number: 22214103.8
(22) Date of filing: 16.12.2022
(51) Int. Cl.: H05K 7/20, H01L 25/10, H01L 25/18, H01L 23/40

(54) **ELECTRONIC DEVICE WITH MOTHERBOARD, POWER CONVERTER MODULE, PROCESSOR MODULE, MEMORY MODULE AND HEAT SINK**

(71) Applicant: AT & S Austria Technologie & Systemtechnik Aktiengesellschaft, 8700 Leoben-Hinterberg (AT)
(72) Inventor: Stahr, Johannes, 8605 St. Lorenzen im Mürztal (AT); Zluc, Andreas, 8700 Leoben (AT)
(74) Representative: Dilg, Haeusler, Schindelmann Patentanwaltsgesellschaft mbH

(57) **Abstract**

An electronic device (100) which comprises a motherboard (102), a power converter module (104), a processor module (106), a memory module (108), and a heat sink (110), wherein at least one of the power converter module (104), the processor module (106) and the memory module (108) is mounted on the motherboard (102) for signal transmission and electric power supply, wherein the heat sink (110) is thermally coupled at least with the processor module (106) and the memory module (108) for removing heat, and wherein the power converter module (104), the processor module (106) and the memory module (108) are arranged between the motherboard (102) and the heat sink (110).

## Description

### Field of the Invention

The invention relates to an electronic device, to a vehicle, and to a method of manufacturing an electronic device.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Component carriers may also form the basis for more complex electronic devices. However, electrical, mechanical and thermal reliability of such electronic devices may be an issue.

### Summary of the Invention

There may be a need to form an electronic device with high degree of electronic functionality and with high thermal reliability.

According to an exemplary embodiment of the invention, an electronic device is provided which comprises a motherboard, a power converter module, a processor module, a memory module, and a heat sink, wherein at least one of the power converter module, the processor module and the memory module is mounted on the motherboard for signal transmission and electric power supply, wherein the heat sink is thermally coupled at least with the processor module and the memory module for removing heat, and wherein the power converter module, the processor module and the memory module are arranged between the motherboard and the heat sink.

According to another exemplary embodiment of the invention, a vehicle is provided which comprises an electronic device having the above-mentioned features.

According to still another exemplary embodiment of the invention, a method of manufacturing an electronic device is provided, wherein the method comprises connecting a motherboard, a power converter module, a processor module, a memory module, and a heat sink, mounting at least one of the power converter module, the processor module and the memory module on the motherboard for signal transmission and electric power supply, thermally coupling the heat sink at least with the processor module and the memory module for removing heat, and arranging the power converter module, the processor module and the memory module between the motherboard and the heat sink.

In the context of the present application, the term "electronic device" may particularly denote a device providing an electronic functionality and being composed of a plurality of electrically and/or thermally interconnected modules.

In the context of the present application, the term "motherboard" may particularly denote a system board of an electronic device on and/or above which plural constituents thereof may be mounted. In particular, a motherboard may be a mounting base of the electronic device, such as a printed circuit board (PCB). A motherboard may provide mechanical support, may be involved in electric signal transmission with at least one other constituent of an electronic device and may be involved in electric energy supply for at least one other constituent of an electronic device.

In the context of the present application, the term "power converter module" may particularly denote a module which converts electric energy from one form to another. In particular, the power converter module may convert a supplied direct electric current into a converted higher direct electric current. Such a power converter module may be embodied as DC (direct current)-DC converter. A DC-DC converter may comprise a plurality of electronic components (such as a controller, at least one transistor (such as a field effect transistor, for example a MOSFET), at least one capacitor and/or at least one inductor) which may be interconnected for providing the direct current conversion function. In other embodiments, it is also possible that a power converter module may convert an alternating current (AC) into a direct current, and/or vice versa, and/or may change the current value, voltage value and/or frequency value.

In the context of the present application, the term "processor module" may particularly denote a module comprising at least one processor. A processor may be an electrical component (in particular a digital circuit) that is configured to form operations on an external data source, for example on a data stream. For instance, a processor may be a microprocessor, a GPU, an FPGA, a semiconductor architecture for high performance computing. A processor may be embodied as semiconductor chip. In particular, a processor may use built-in transistors.

In the context of the present application, the term "memory module" may particularly denote a module comprising at least one memory component. A memory component may be an electronic component (in particular a semiconductor chip) which may be configured for data storage, in particular digital data storage. In particular, such a memory component may be embodied as metal-oxide-semiconductor (MOS) memory, where data is stored within MOS memory cells on a silicon integrated circuit memory chip.

In the context of the present application, the term "heat sink" may particularly denote a (for example passive) heat exchanger that transfers heat generated by an electronic module (in particular the processor module and/or the memory module) to a fluid medium, such as air or a liquid coolant such as water, where it is dissipated away from said electronic module. For example, a heat sink may comprise a highly thermally conductive body (for instance made of copper or aluminum) comprising a plate being thermally coupled with said electronic module to be cooled, wherein a plurality of cooling fins may extend from the plate and may dissipate the heat towards an environment. Alternatively, a heat sink may comprise a liquid cooling module, for instance a water cooling module.

In the context of the present application, the term "module" may particularly denote an electronic member (in particular at least one of the above mentioned processor module, memory module, power conversion module) of the electronic device which may comprise at least one electronic component (such as a semiconductor chip), preferably encapsulated in an encapsulant and/or being surface mounted on a support structure. The electronic function provided by a module may be realized in a hard-wired fashion. Furthermore, it is possible that the electronic function of a module is provided partially or entirely in software. In particular, a module may be a laminate-type module, a mold-type module or a module based on an inorganic carrier. For example, any module may be a component carrier, such as a printed circuit board (PCB) or an integrated circuit (IC) substrate, having at least one embedded electronic component and/or at least one surface mounted electronic component. Alternatively, it is possible that a respective module comprises at least one electronic component being encapsulated in a mold compound. A respective module may also be formed based on an inorganic carrier such as a ceramic plate or a glass plate.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers. In particular, a component carrier may comprise a stack comprising a plurality of electrically conductive layer structures and/or electrically insulating layer structures.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the (in particular laminated) layers may be parallel shifted (in stack thickness direction) in space.

In the context of the present application, the term "layer structure" may particularly denote a continuous layer, a patterned layer or a plurality of nonconsecutive islands within a common plane.

In the context of the present application, the term "vehicle" may particularly denote any machine that transports people or cargo. For example, the vehicle may be configured as automobile, aircraft, spacecraft, watercraft or railway vehicle. In particular, vehicles include motor vehicles (such as motorcycles, cars, trucks, buses, scooters), railed vehicles, watercraft, amphibious vehicles, aircraft and spacecraft.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment of the invention, an electronic device comprises a power converter module for providing an electric power conversion functionality, a processor module providing a data processing functionality and a memory module providing a data storage functionality. At least one, preferable two of them, may be mounted directly (i.e. without module and / or layer structure(s) in between) or indirectly (i.e. with at least one module and / or at least one layer structure in between) on a motherboard. The electric interconnection between the motherboard, the power converter module, the processor module and the memory module may be so that a transmission of electric signals for providing an electronic functionality as well as an electric power supply for accomplishing supply of electric power at least to the processor module and / or the memory module can be achieved. Furthermore, a heat sink may be thermally coupled at least with the processor module and the memory module for removing heat generated during operation of the electronic device. Advantageously, the power converter module, the processor module and the memory module are arranged between the motherboard on the one hand and the heat sink on the other hand. This architecture may allow to create a single-sided cooling path from the centrally arranged power converter module, processor module and memory module towards the heat sink. At the same time, signal transmission and electric energy supply may be managed along a spatially separated other path between, on the one hand, the motherboard and, on the other hand, the power converter module, processor module and memory module. Such an architecture may be highly advantageous in particular for vehicle applications (for instance for autonomous drive control or electric motor control) where in many cases no sufficient space is available for double-sided cooling and where several modules with different functionalities are needed. The described architecture is compatible with limitations concerning a single-sided cooling environment, while simultaneously ensuring a high thermal reliability and a high electric reliability.

### Detailed Description of Exemplary Embodiments

In the following, further exemplary embodiments of the electronic device, the vehicle, and the method will be explained.

In an embodiment, the different modules may be physically and/or electrically connected via pads, pumps, and/or balls.

In an embodiment, the motherboard is connected for transmitting signals to the processor module and the memory module and electric power to the power converter module. High speed data transmission may occur between the processor module and the memory module. Thus, the motherboard may provide electric signals both to the processor module and the memory module. For example, this signal supply may be from the motherboard directly to the processor module and the memory module, or from the motherboard directly to the processor module and from there to the memory module. Furthermore, the motherboard may provide electric supply current to the power converter module which may execute power conversion and may then provide the converted power to the processor module. The memory module may receive electric power as provided by the motherboard, or as converted by the power converter module. Normally, processor and memory may have their own power supply with low voltage. In an embodiment, the motherboard may deliver higher voltage to the power supply module for the processor module and the memory module. The provision of electric signals and the electric power to the above mentioned modules provides the advantage of an easier definition of the electrical connections, leading to a compact and easy connections layout, due to the clear positioning of the several modules each having a specific function and / or specific (for instance electrical) requirements.

In an embodiment, the motherboard and the memory module may have the same current and/or voltage. However, the processor module may be operated with different current and/or voltage. The motherboard may have different current and/or voltage relative to the memory module and relative to the processor module. Hence, three different current and/or voltage regimes may be involved. Therefore, the processor module may have one input and two different outputs, or two processor modules may be used to convert.

In an embodiment, the power converter module is configured for converting an input current and an input voltage into a larger output current and a smaller output voltage. For example, the power converter module may be configured for providing an output current of at least 10 A or at least 30 A, in particular at least 50 A, for instance in a range from 100 A to 500 A. An input current provided from the motherboard to the power converter module may be for example in a range from 5% to 50% of the output current provided at an output of the power converter module. For instance, the conversion may be from 5 V to 1 V, from 12V to 1V, or from 48 V to 1 V. For this purpose, it is possible that a DC-DC converter forms part of the power converter module. The integration of the power converter module in the electronic device provides a compact electronic device with several functional modules integrated therein, each having specific electrical requirements (such as specific power supply values, i.e. specific current and voltage values) opportunely connected to each other for a proper and a short-distance electrical connection.

In an embodiment, the power converter module is a plate-shaped board. For example, said plate-shaped board may be a component carrier, such as a printed circuit board. This may contribute to a flat and compact design of the electronic device as a whole. A DC-DC converter, which may form part of the power converter module, may comprise a plurality of electronic components (such as active components, like a MOSFET, and/or passive components, such as a capacitor and/or an inductor) which may be embedded in a component carrier of the power converter module.

In an embodiment, the processor module and the memory module are configured for cooperating to provide a common functionality. In particular, the processor module may be configured for processing data which may be stored, in original and/or processed form, in the memory module. Thus, the processor module and the memory module may functionally cooperate. For instance, they may provide, together, a high performance computing (HPC) functionality, for example for an automotive application such as autonomous driving. More generally, the processor module may be a computing module and the memory module may be a data storage module being coupled for data exchange with the processor module.

In an embodiment, the heat sink is configured for removing heat from the processor module and from the memory module along thermally separated heat removal paths so that the processor module and the memory module are thermally decoupled from each other. During operation of the electronic device, the processor module may be the most intense heat source of the electronic device, so that cooling thereof may be of utmost advantage. At the same time, the memory module may be very temperature sensitive, for instance may have to be operated reliably at a temperature of not more than 85°C. Consequently, cooling of the memory module may be an important task. When sharing the same heat sink (which may be advantageous in view of a compact design), the heat removal path for removing heat from the processor module may thus be spatially and thermally separated from another heat removal path for removing heat from the memory module. By taking this measure, an undesired cross-flow of heat from the processor module to the memory module may be reliably prevented. Additionally, the power converting module may be directly or indirectly connected to the heat sink to not spread heat in order to ensure that memory module and processor module work more efficiently.

In an embodiment, the electronic device is functionally divided into a bottom-sided signal processing domain (including the motherboard and electrically connected portions of processor module, memory module, converter module) and into a top-sided heat removal domain (including the heat sink and thermally coupled portions of processor module, memory module, converter module). By such a spatial separation of electric and thermal tasks, application-related limitations concerning heat removal via one side of the electronic device only may be complied with. Furthermore, any undesired impact of excessive heat to signal and power management may be reliably prevented.

In an embodiment, the electronic device is configured for single-sided cooling via the heat sink. Thus, one or more thermal paths towards the heat sink may be configured so as to enable heat removal with much lower thermal resistance compared with other potential heat removal paths. Consequently, a clear spatial separation of electric current flow and heat flow may be ensured by an inhomogeneous adjustment of the thermal conductivity over an extension of the electronic device.

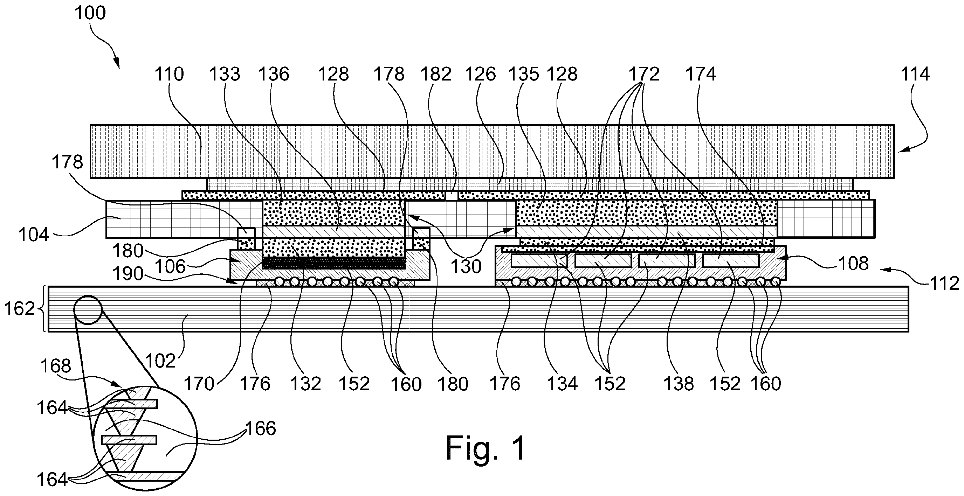

In an embodiment, the processor module and the memory module are mounted side-by-side (i.e. laterally next to each other - with respect to the vertical extension of the electronic device, preferably perpendicular to the two opposed main surfaces) on the motherboard or on the power converter module, in particular embedded in a common plate-shaped board. Preferably, the processor module and the memory module may not be in direct physical contact. Such embodiments are shown for instance in Figure 1 to Figure 3. Alternatively, the processor module and the memory module may be in direct physical contact. This may lead to a high compactness in vertical direction and may simplify independent cooling of processor module and memory module.

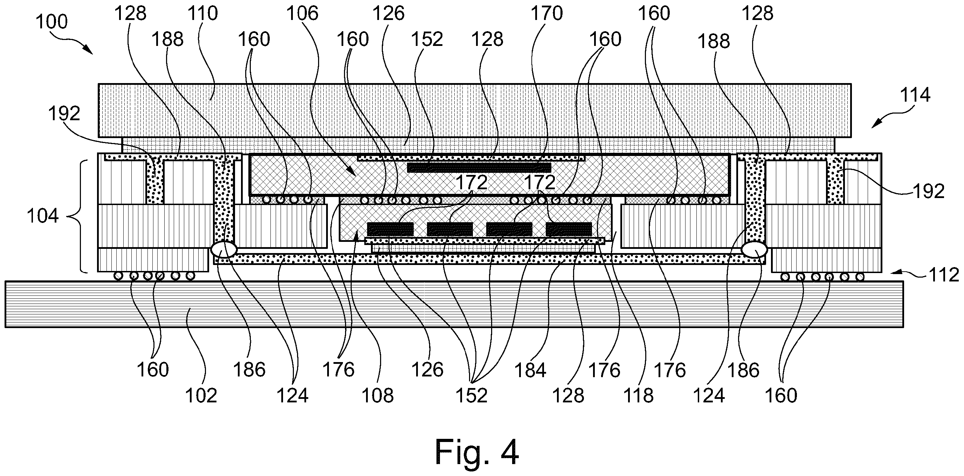

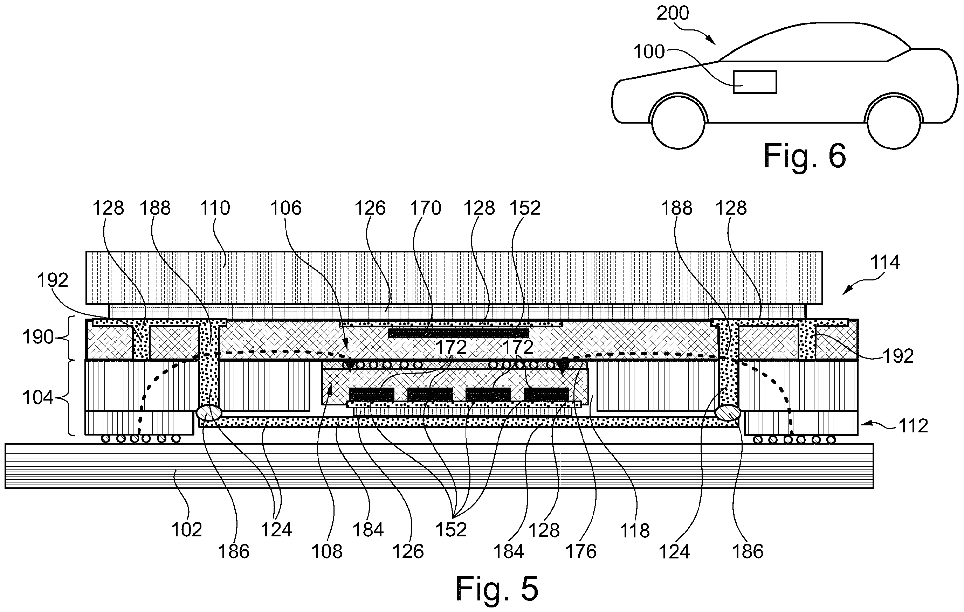

In another embodiment, the processor module and the memory module are vertically stacked above each other. Such embodiments are shown for instance in Figure 4 and Figure 5. This may simplify manufacture of the electronic device, since processor module and memory module may be inserted into a common (in particular stepped) cavity. Furthermore, such a design may shorten electric paths between processor module and memory module and may therefore reduce signal losses and improve signal quality.

In an embodiment, a Peltier element may be provided to guide heat to protect for instance the memory module against overheating. A Peltier cooler may add additional power to the system which may need to be removed over the heat sink. This may be an option for the memory module which may be more temperature sensitive and may run on lower power as the processor module.

In an embodiment, the processor module is mounted above the memory module. Consequently, the processor module may be arranged closer to a top-sided heat sink than the memory module. Since the processor module is in many cases the more pronounced heat source than the memory module, a more efficient heat removal can be ensured by the mentioned design rule.

In an embodiment, the processor module and the memory module are accommodated in a cavity in an interior of the electronic device. A cavity may be a hollow volume (for instance formed by a blind hole or a through hole) in the electronic device, in particular in the power converter module. The processor module and the memory module may then be reliably protected in an interior of the electronic device. Additionally, a dielectric material, in particular a thermal interface material (TIM), may be accommodated in the cavity configured to fill up an empty space between at least one (for example side) wall of the cavity and at least one (for example side) wall of the processor module and/or the memory module.

In an embodiment, the cavity has a narrower section and a wider section for accommodating the processor module and the memory module having different lateral extensions. The width of the respective section may correspond to the width of the respective module (i.e. processor module or memory module) accommodated therein. Such a stepped cavity - in particular in the power converter module - may allow for a simple and space efficient assembly of the processor module and the memory module while simultaneously avoiding excessive voids in an interior of the electronic device.

In an embodiment, the electronic device comprises a thermal bypass structure thermally coupling the lower one of the processor module and the memory module with the heat sink and extending around the upper one of the processor module and the memory module. When the processor module and the memory module are vertically stacked between the motherboard and the heat sink, a vertical spacing between the lower one of the processor module and the memory module (preferably the memory module, being usually less demanding what concerns heat removal performance as compared with the processor module) and the heat sink may be pronounced. In order to improve the thermal coupling between said lower module and the heat sink, a thermal bypass structure may be formed connecting a bottom side of said lower module by a highly thermally conductive structure laterally surrounding the upper of said modules (preferably without the thermal connection between the thermal bypass structure and the upper of said modules) and extending towards the heat sink. For example, the thermal coupling at said bottom side may be accomplished by a metal plate such as a clip (preferably meaning as clip a metal plate mounted, associated and/or connected on the lower module and the rest of the bypass structure connected to the heat sink). The laterally surrounding thermally conductive structure may be created by one or more thermal vias which may be thermally connected with the metal plate. Between the upper end of the respective thermal via and the heat sink, an optional thermal interface material (TIM) may be provided. By the described architecture, a proper cooling of vertically stacked processor and memory modules may be ensured.

In an embodiment, the heat sink is thermally coupled with the processor module and the memory module via a thermal coupling layer of thermal interface material (TIM) and/or via a metallic heat spreader layer (for instance a copper layer) in between. In particular, the thermal coupling layer and/or the metallic heat spreader layer may form a monolithic body having no empty space or cavity. For example, the thermal interface material may be a thermally conductive grease for improving the heat transfer between the heat sink and a thermally connected structure (such as the processor module and/or the memory module, the aforementioned thermal bypass structure, etc.). A heat spreader layer may also have an impact on the direction of the heat flow, and may in particular promote heat flow in a lateral direction.

In an embodiment, the thermal coupling layer and/or the metallic heat spreader layer is or are interrupted (laterally) between the processor module and the memory module. Such an interruption may reliably decouple the heat removal paths between processor module and heat sink and between memory module and heat sink. The interruption or gap of thermal coupling layer and/or heat spreader layer between processor module and memory module (when arranged side-by-side) may inhibit a lateral heat flow in particular from the processor module to the memory module.

When using a separation of heat sinks laterally, the heat sinks may be electrically disconnected. With this construction, the heat sinks can be directly soldered to the modules and the thermal resistance of the configuration may be reduced.

In an embodiment, the power converter module is arranged vertically in between, on the one hand, the processor module and the memory module and, on the other hand, the heat sink. Such an embodiment is shown for instance in Figure 1 and may provide a particularly advantageous power supply performance dividing the heat path from the signal path, being the modules involving the electrical signal on the side opposed to the heat sink and the respective thermal coupling.

In an embodiment, the processor module is connected for transmission of electric power from the motherboard to the power converter module via the processor module, and optionally via the memory module. Furthermore, the processor module and the power converter module may be connected for transmission of converted electric power from the power converter module to the processor module, and optionally to the memory module. Hence, the electric power provided from the motherboard may be guided through the processor module to the power converter module. After power conversion, the electric power (preferably at higher current value) may be guided back into the processor module. Optionally, also the memory module may be involved in said power management chain. The resulting processor module then allows a bidirectional management of the electric power, on one hand transmitting it toward a further component, on the other hand receiving it once processed, leading to an efficient and compact way to manage the electric power in a single electronic device.

In an embodiment, the electronic device comprises a vertically extending thermal coupling arrangement between the processor module and the heat sink, and optionally between the memory module and the heat sink, for thermally coupling the processor module, and optionally the memory module, through the power converter module to the heat sink. In such a configuration, the power converter module may be additionally provided with the function of heat transfer and/or heat coupling between at least one module and the heat sink, leading to an optimized and compact layout of the electronic device. Preferably, the vertically extending thermal coupling arrangement may comprise highly thermally conductive blocks being vertically connected with each other preferably by a highly thermally conductive connection medium, in particular a sinter depot (see for instance Figure 1). Such a thermal coupling arrangement may be in particular advantageous in a configuration in which the power converter module is vertically sandwiched between the processor module and the memory module on the one hand and the heat sink on the other hand. In such a configuration, heat generated by the processor module and the memory module may be guided away from the motherboard along a short vertical thermal path extending through the power converter module towards the heat sink. The highly thermally conductive blocks may for instance be copper inlays interconnected with a thermally conductive medium, such as a metallic sinter paste. The highly thermally conductive blocks may have edged shapes (e.g. rectangular) and/or round shapes (e.g. cylindrical). The thermally conductive blocks can be larger than the chip size to enable heat spreading and enable a further reduction of the thermal resistance. This architecture may allow to establish an efficient cooling path from the processor module and/or the memory module to the heat sink even when the power converter module is arranged vertically in between. In addition, cooling of the power converter module is a simple task in the described embodiment, in view of the close spatial vicinity of the power converter module and the heat sink.

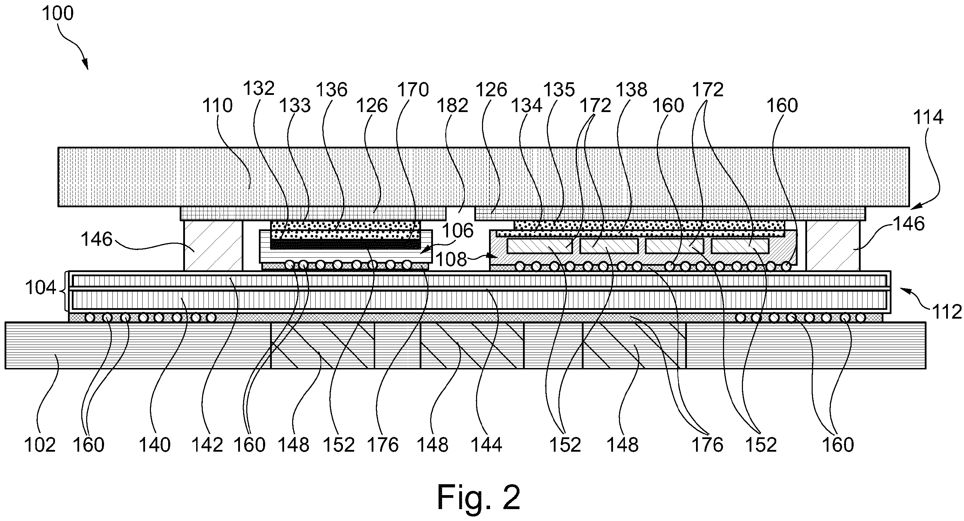

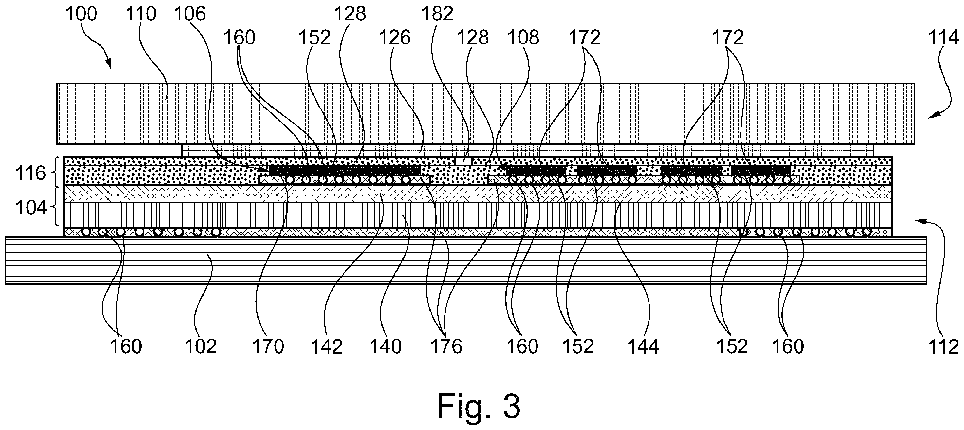

In another embodiment, the power converter module is arranged vertically in between, on the one hand, the motherboard and, on the other hand, the processor module and the memory module. Corresponding embodiments are shown for instance in Figure 2 and Figure 3. Such a location of the constituents of the electronic device may simplify cooling of processor module and memory module and may also promote compactness of the electronic device in vertical direction. Cooling of the critical components may be promoted by the close spatial vicinity between the processor module and/or the memory module on the one hand and the heat sink on the other hand. Vertical compactness may be achieved, since the described manufacture is compatible with a side-by-side arrangement of processor module and memory module. Moreover, the placement of the processor module and the memory module on the side of the power converter module that is opposed with respect to the side where the motherboard is provided, allows a (reliability and/or functioning) test of the assembled motherboard and the power converter module before the assembly of the processor and the memory modules, the latter comprising expensive components, leading to an efficient, reliable and cheap way to manufacture the electronic device comprising several modules.

In an embodiment, the processor module and the memory module may have the same thickness in stack direction. Alternatively, the processor module and the memory module may have different thickness in stack direction. Memory module and processor module need to have the same height after assembly to the power module in Figure 2 to enable the usage of a thin TIM layer. In Figure 3, a planarization process can be done after assembly and overmolding to achieve planarity.

In an embodiment, the power converter module comprises a bottom-sided lower density connection region coupled with the motherboard and a top-sided higher density connection region coupled with the processor module and the memory module. In particular, the power converter module may comprise a redistribution structure in an interface region between the bottom-sided lower density connection region and the top-sided higher density connection region. Different regions of the power converter module may be provided with a different density of electrically conductive wiring elements, i.e. a different number of wiring elements per volume or area. The lower density connection region of the power converter module at its bottom side may form an interface with the motherboard which may have a correspondingly small, in particular the same, density of wiring elements. The higher density connection region of the power converter module at its top side may form an interface with the processor module and/or the memory module which may have a correspondingly high, in particular the same, density of wiring elements. In particular, a redistribution layer (RDL) or another kind of redistribution structure may be integrated or embedded in the power converter module for providing a conversion between the lower density and the higher density of wiring elements. Such a redistribution structure may provide an interface between larger pitches of PCB technology and smaller pitches of semiconductor technology.

In an embodiment, the bottom-sided lower density connection region is configured for power conversion (for instance up to a power of at least 80 W or even at least 200 W or at least 500 W) and the top-sided higher density connection region is configured for signal supply. Hence, the mentioned connection regions may be configured differently so as to specifically comply with their intended functions. Consequently, a power converter module with heterogeneous construction may be provided.

In an embodiment, the electronic device comprises a vertically extending thermal coupling arrangement bypassing the processor module and the memory module (i.e. without thermally connecting the processor module and the memory module) for thermally coupling the power converter module with the heat sink. Such an embodiment is shown for instance in Figure 2. When the processor module and the memory module are sandwiched vertically between the power converter module and the heat sink, adequate cooling of processor module and memory module as well as an advantageous supply of signals and energy may be guaranteed. However, heat removal from the power converter module may be challenging in such an embodiment, since the power converter module is then spaced with respect to the heat sink by the processor module and by the memory module. In order to ensure proper cooling of the power converter module as well, it is possible to provide a vertically extending thermal coupling arrangement, for instance in form of one or more metallic pillars (for example copper pillars), for thermally connecting the power converter module with the heat sink (in particular by an additional thermal interface material (TIM) at a bottom side of the heat sink). This thermal coupling arrangement can comprise a copper ring around the module which is soldered to the power converter module.

In an embodiment, the electronic device comprises an embedded thermal coupling arrangement in the motherboard for removing heat from the power converter module through the motherboard. Additionally or alternatively to the aforementioned provision of a vertically extending thermal coupling arrangement, it may also be possible to cool the power converter module when arranged vertically between the motherboard on the one hand and the processor module and the memory module on the other hand by one or more highly thermally conductive inlays embedded in the motherboard. Said highly thermally conductive inlays (for instance made of copper) are a preferred embodiment for the embedded thermal coupling arrangement. Such an embodiment may be advantageous in a configuration in which double sided cooling is allowed by the design of the specific application.

In an embodiment, the electronic device comprises a redistribution structure in the motherboard and/or in the power converter module. In the context of the present application, the term "redistribution structure" may particularly denote an arrangement of interconnected patterned electrically conductive layers which connect a portion having a lower pitch with another portion having a higher pitch. "Pitch" may denote a characteristic distance between adjacent electrically conductive elements, such as trace elements and/or connection elements. For instance, the pitch may be the center-to-center distance of contact pads of components or the center-to-center distance of via connections in a substrate or a PCB. By connecting spatially separate portions with different pitch, a redistribution structure may form an electric interface between larger dimensioned electric connection elements and smaller dimensioned electric connection elements. In particular, a number of electrically conductive elements per area may be smaller in a portion with larger pitch than in another portion with smaller pitch. Such a transition between technologies of different pitches may be accomplished selectively in the motherboard and/or in the power converter module.

In an embodiment, at least one, in particular at least some, more particularly each of the motherboard, the power converter module, the processor module, and the memory module comprises a laminate-type and/or plate-shaped component carrier, optionally with at least one embedded component. Advantageously, one, some or all of the above-mentioned constituents of the electronic device may be embodied as laminate-type component carrier, such as a printed circuit board (PCB). In such a configuration, the electronic device may be manufactured with high vertical compactness and in a simple way. Furthermore, a CTE (coefficient of thermal expansion) mismatch may be small and a thermal and mechanical reliability may be excellent when the various modules are made of very similar material. At the same time, PCB technology is highly appropriate for embedding components, such as semiconductor chips. Such semiconductor chips may be used as processor chip(s) of the processor module, as memory chip(s) of the memory module, and/or for constructing a DC-DC converter (or another power converter circuitry) of the power converter module.

In an embodiment, the component carrier comprises a stack which comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the further component may also be an IC substrate, an interposer or a further component carrier, for example in a board-in-board configuration. The further component may be surface mounted on the component carrier and/or may be embedded in an interior thereof.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In an embodiment, the component carrier related body is a laminate-type component carrier. In such an embodiment, the component carrier is a compound of multiple layer structures which are stacked and connected together by applying a pressing force and/or heat.

The aspects defined above and further aspects of the invention are apparent from the examples of embodiment to be described hereinafter and are explained with reference to these examples of embodiment.
Figure 1 illustrates a cross-sectional view of an electronic device according to an exemplary embodiment of the invention.
Figure 2 illustrates a cross-sectional view of an electronic device according to another exemplary embodiment of the invention.
Figure 3 illustrates a cross-sectional view of an electronic device according to still another exemplary embodiment of the invention.
Figure 4 illustrates a cross-sectional view of an electronic device according to still another exemplary embodiment of the invention.
Figure 5 illustrates a cross-sectional view of an electronic device according to still another exemplary embodiment of the invention.
Figure 6 illustrates a vehicle comprising an electronic device according to an exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Conventionally, high density integration (HDI) applications may be realized with assembled memory components (usually in surface mounted device (SMD) technology). Furthermore, a processor package may be soldered on a motherboard. Electric and thermal reliability of such electronic devices may be an issue, as well as losses during transmission of electrical signals.

According to an exemplary embodiment of the invention, an electronic device is provided which is particularly appropriate for vehicle applications and other applications in which cooling of the electronic device is in many cases only possible along one side thereof, while simultaneously having demanding requirements concerning electronic performance. An electronic device according to an exemplary embodiment of the invention complies with these contradicting requirements by providing a high thermal reliability combined with high electronic performance. At the same time, the electronic device can be manufactured in a highly compact way. A corresponding electronic component may comprise a motherboard, a power converter module, a processor module, a memory module, and a heat sink as constituents, for example as main or sole constituents. Advantageously, one or more of the power converter module, the processor module and the memory module is or are mounted on the motherboard in a way enabling transmission of electric signals and supply of electric power. Furthermore, the heat sink may be thermally coupled at least with the processor module and with the memory module for removing heat from these heat sources of the electronic device. Advantageously, the power converter module, the processor module and the memory module may be arranged between the motherboard and the heat sink. With this arrangement, heat flow can be enabled away from the processor module and the memory module and predominantly towards the heat sink. Furthermore, the electronic path may be spatially separated from the thermal path, so that excessive heat is also prevented from propagating towards the signal propagation and the energy supply path.

According to an exemplary embodiment, an electronic device is provided which is configured as a modularized package of constituents including a processor module, a memory module and a power-converting power supply module. Also passive components, such as inductors, capacitors, etc., may be provided. Electronic devices according to exemplary embodiments of the invention may be configured as single sided cooling package which may be adapted or even optimized concerning interconnection and power requirements, focusing predominantly on power requirements, concerning cooling requirements, or concerning supply chain requirements.

An electronic device according to an exemplary embodiment of the invention may be manufactured by executing a module bonding process with embedded components. In particular, such electronic components may be embedded in a substrate and/or a PCB. Hence, a modularized package may be provided which is highly appropriate for high performance computing (HPC) applications. Hence, an electronic device according to an exemplary embodiment of the invention may be configured as HPC device for a vehicle application, preferably for autonomous driving with artificial intelligence (AI) function.

With a connection architecture of an electronic device according to an exemplary embodiment of the invention, a smart compilation of superstructures may be achieved. This may enable high bandwidth data transmission. Furthermore, a reduction of the number of involved compounds may become possible. Connection lengths between different modules of the electronic device may be significantly shortened. This may have a positive impact on signal losses, signal distortion and an amount of generated heat. Moreover, an electronic device according to an exemplary embodiment of the invention may provide an arrangement of its modules allowing an efficient cooling of its modules and components (for example memory module and processor module). Furthermore, an efficient trade-off between cooling requirements and conductor length may be made. A manufacturing technology according to an exemplary embodiment of the invention may keep the length of the conductors small and may lead to a small heat resistance in view of the spatial and modular arrangement. Furthermore, by shortening of the lines, signal losses will be reduced.

An electronic device according to an exemplary embodiment of the invention provides a modular construction for high data bandwidth transmission, and is therefore highly appropriate for applications, such as HPC computing. Hence, an electronic device of an embodiment enables a very high-bandwidth for digital data transmission between processor module and memory module with excellent thermal cooling performance. More specifically, this may be achieved for a single sided cooling architecture, thereby complying with demanding boundary conditions which may be present, for example, in automobile applications, for instance autonomous driving applications.

An electronic device according to an exemplary embodiment of the invention may be configured as a package for an automotive application with a focus on efficiency while allowing to optimize electric power and cooling performance. Exemplary embodiments of the invention may provide an arrangement of a motherboard, a power converter module, a processor module, a memory module and a heat sink for efficiently guiding electric power and electric signals as well as each through defined paths in the electronic device. A corresponding connection architecture may provide short communication lines between memory module and processor module while simultaneously allowing a high-power transfer and a proper cooling.

An exemplary embodiment provides one board for power conversion (i.e. the power converter module) and another board for power and signal supply (i.e. the motherboard), while additionally providing a heat sink for efficiently cooling the electronic device. A processor module and a memory module may be assembled in between the aforementioned constituents of the electronic device, may consume supplied power, may handle signals and may dissipate waste heat to the heat sink. The functional and structural separation between heat and electricity related tasks provides the basis for a spatial separation of a power and signal propagation path with respect to another heat dissipation path. In other words, a heat removal domain may be separated from a signal and power domain of the electronic device.

**Figure 1** illustrates a cross-sectional view of an electronic device 100 according to an exemplary embodiment of the invention.

The illustrated electronic device 100 may be configured as an autonomous drive controller in a car and may execute high-performance computing tasks for this purpose. In such an application scenario in a car, one limitation to be considered may be that only single sided cooling complies with a specification. At the same time, highly efficient cooling of the main heat sources of the electronic device 100 as well as an efficient power and signal distribution may be of utmost advantage.

In order to comply with the above-mentioned demands, the electronic device 100 comprises a bottom-sided motherboard 102 as an electronic and mechanical mounting base and for providing electric power and electric signals. Furthermore, the electronic device 100 comprises a power converter module 104 for converting electric power to an appropriate level (in particular to an elevated current level). Moreover, the electronic device 100 comprises a processor module 106 for processing signals when being supplied with sufficiently high electric power. Beyond this, a memory module 108 is provided for temporarily and/or permanently storing data corresponding to processed signals and/or results of signal processing. As shown in Figure 1, the processor module 106 and the memory module 108 can be mounted side-by-side on the motherboard 102. Preferably, the processor module 106 and the memory module 108 are configured for cooperating to provide a common electronic functionality, such as the above-mentioned autonomous drive function. Furthermore, the electronic device 100 comprises a top-sided heat sink 110 for removing heat generated predominantly by the processor module 106 and additionally by the memory module 108 and the power converter module 104. According to Figure 1, the power converter module 104 is arranged vertically in between, on the one hand, the processor module 106 and the memory module 108 and, on the other hand, the heat sink 110. Optionally, empty gaps between the constituents of the electronic device 100 may be overmolded (not shown).

In the shown embodiment, the motherboard 102 is embodied as a printed circuit board (PCB). Thus, the motherboard 102 shown in Figure 1 may be highly compact in a vertical direction. More specifically, the motherboard 102 may comprise a stack 162 comprising electrically conductive layer structures 164 and electrically insulating layer structures 166 (see detail 168). The electrically conductive layer structures 164 may comprise patterned metal layers (such as patterned copper foils or patterned deposited copper layers) and vertical through connections, for example copper filled vias, which may be created by drilling and plating. The electrically insulating layer structures 166 may comprise a respective resin (such as a respective epoxy resin), preferably comprising reinforcing particles therein (for instance glass fibers or glass spheres). For instance, the electrically insulating layer structures 166 may be made of FR4. The electrically insulating layer structures 166 may also comprise resin layers being free of glass fibers.

On top of the motherboard 102, the processor module 106 and the memory module 108 are connected by soldering using solder structures 160 (such as micro solder balls). Gaps or empty spaces at a bottom side of the processor module 106 and of the memory module 108 may be filled with a dielectric underfill 176.

In the shown embodiment, each of the processor module 106 and the memory module 108 is configured as a component carrier (in particular a PCB, which may be constructed for instance as described for motherboard 102). The processor module 106 comprises a processor semiconductor chip 170 which is embedded in an encapsulant (in the described embodiment a laminate, alternatively a mold compound). It is also possible that a plurality of processor semiconductor chips 170 form a processor module 106 (not shown). The memory module 108 comprises a plurality of memory semiconductor chips 172 which are embedded in an encapsulant (in the described embodiment a laminate, alternatively a mold compound). It is also possible that only a single memory semiconductor chip 172 is present in a memory module 108 (not shown). In the shown embodiment, the processor semiconductor chip 170 and the memory semiconductor chips 172 are embodied as embedded components 152. Alternatively, they may also be surface mounted components. Preferably, the processor semiconductor chip(s) 170 and/or the memory semiconductor chip(s) 172 may be known-good chips which have been successfully tested before assembly. This may increase the yield of manufacturing electronic devices 100, in particular when a chip last manufacturing process is carried out.

On top of the processor module 106 and of the memory module 108, which may be arranged side-by-side at the same vertical level, the power converter module 104 is assembled. Preferably, the processor module 106 and the memory module 108 may be spaced to each other in order to not transfer heat from one module to the other module. The power converter module 104 can also be embodied as a component carrier (such as a PCB, for instance constructed as described above for the motherboard 102). Although not shown, the power converter module 104 may comprise a DC-DC converter for converting an input current into a larger output current. Such a DC-DC converter may comprise a plurality of embedded components, such as at least one controller chip, at least one transistor chip, at least one capacitor and at least one inductor.

A top layer of the motherboard 102 may be configured for connection of power and signals and is denoted with reference sign 190 in Figure 1. Wiring structures (preferably made of copper) in power converter module 104 may be sufficiently thick for transferring high current, and may be thicker than finer signal lines coupling signals into processor module 106. A signal transfer between processor module 106 and memory module 108 may be carried out by a wiring structure located in a top portion of the motherboard 102 of Figure 1.

Furthermore, the power converter module 104 of Figure 1 comprises a plurality of highly thermally conductive blocks 132, 133, 134, 135 (such as copper blocks or copper inlays) forming a vertically extending thermal coupling arrangement 130. Some of the thermally conductive blocks 132-135 are embedded in an interior of the power converter module 104, other ones protrude beyond main surfaces of the power converter module 100. As shown in Figure 1, the vertically extending thermal coupling arrangement 130 extends between the processor module 106 and the heat sink 110 and extends in parallel between the memory module 108 and the heat sink 110. This serves for thermally coupling the processor module 106 and the memory module 108 through the power converter module 104 to the heat sink 110, while the heat removal path from processor module 108 to heat sink 110 is thermally decoupled from the parallel heat removal path from memory module 106 to heat sink 110. This avoids an undesired cross flow of heat from processor module 106 to temperature sensitive memory module 108. As shown as well, the vertically extending thermal coupling arrangement 130 comprises the highly thermally conductive blocks 132-135 being vertically connected with each other by a highly thermally conductive connection medium 136, 138, which is here embodied as a sinter depot. Highly thermally conductive blocks 132, 134 are surface mounted on, whereas highly thermally conductive blocks 133, 135 are embedded in the component carrier stack of the power converter module 104. The respective surface mounted highly thermally conductive block 132, 134 is thermally coupled with the processor semiconductor chip 170 or the memory semiconductor chips 172, respectively. Vertically stacked pairs of highly thermally conductive blocks 132, 133 and 134, 135 are vertically interconnected by a respective one of the highly thermally conductive connection media 136, 138, for example a sinter depot. On top of the respectively upper one of the highly thermally conductive blocks 133, 135 a metallic heat spreader layer 128 (for instance a copper layer) is arranged. A top side of the metallic heat spreader layer 128 is thermally coupled via a thermal coupling layer 126 (such as a thermal interface material, TIM) with the above-mentioned heat sink 110. Thus, the heat sink 110 is thermally coupled with the processor module 106 and the memory module 108 via the thermal coupling layer 126 of thermal interface material, via the metallic heat spreader layer 128, and via the vertically extending thermal coupling arrangement 130 in between. A further heat transfer coupling layer 174 may be arranged between the memory semiconductor chips 172 of the memory module 108 and the surface mounted highly thermally conductive block 134 for further promoting heat transfer. By the described thermal paths, the heat sink 110 is thermally coupled with the processor module 106 and the memory module 108 for removing heat. Furthermore, the heat sink 110 is thermally coupled with the power converter module 104 via the thermal coupling layer 126 of thermal interface material and via the metallic heat spreader layer 128 for efficiently dissipating heat also from the power converter module 104.

In this embodiment, the processor module 106 and the memory module 108 as well as the conductive connection medium 136, 138 and highly thermally conductive blocks 132, 133 and 134, 135 and metallic heat spreader layer 128 may have the same thickness in stack thickness direction, respectively. If the memory module 108 and the processor module 106 do not have the same thickness, at least one of the conductive connection media 136, 138, highly thermally conductive blocks 132, 133 and 134, 135, metallic heat spreader layer 128 or thermal coupling layer 126 may compensate the thickness difference in order to reach the same height for connecting to heat sink 110.

Now referring to the heat sink 110, the latter may be made of a highly thermally conductive material such as copper or aluminum. In the context of the present application, a highly thermally conductive material may have a thermal conductivity of at least 50 W/mK, preferably of at least 100 W/mK. The heat sink 110 is only shown schematically in the figures and may be embodied as a member which efficiently removes heat in particular from the processor module 106 (which may be the main heat source of electronic device 100) and additionally from the memory module 108 and the power converter module 104 (which may also generate a considerable amount of heat during operation). For instance, the heat sink 110 may be embodied as a highly thermally conductive plate with a plurality of integrated cooling fins. It is also possible that the heat sink 110 comprises a liquid cooling device, for instance a water cooling device. Many other embodiments for the heat sink 110 are possible.

Electrically conductive contacts 180 at a top side of the processor module 106 may be electrically coupled with electrically conductive contacts 178 at a bottom side of the power converter module 104. By the electrically conductive contacts 178, 180, electric power may be transferred from the motherboard 102 via the processor module 106 to the power converter module 104 for subsequent power conversion. The processor module 106 is mounted on the motherboard 102 for contributing to signal transmission and electric power supply. For instance, signal lines and power lines may be arranged between the motherboard 102 and the power converter module 104. The processor module 106 is connected for transmission of electric power from the motherboard 102 to the power converter module 104 via the processor module 106. Moreover, the processor module 106 and the power converter module 104 are connected for transmission of converted electric power back from the power converter module 104 to the processor module 106, and optionally also to the memory module 108. By the electrically conductive contacts 178, 180, electric power may be transferred from the motherboard 102 through the processor module 106 (optionally through the memory module 108) into the power converter module 104 (which may also be denoted as power supply module).

According to Figure 1, the power converter module 104, the processor module 106 and the memory module 108 are arranged between the motherboard 102 and the heat sink 110. By taking this measure, the electronic device 100 may be functionally divided into a bottom-sided power supply and signal processing domain 112 and into a top-sided heat removal domain 114. Significant heat flow to the bottom side of Figure 1 may be inhibited by configuring the motherboard 102 with a much smaller thermal conductivity than the heat sink 110. In view of this configuration, the electronic device 100 is configured for single-sided cooling via the heat sink 110 only.

As already mentioned, the motherboard 102 is connected for transmitting signals to the processor module 106 and the memory module 108 and electric power to the power converter module 104. Apart from this, the above-mentioned DC-DC converter of the power converter module 104 may be configured for converting an input current (for example 20 A) and an input voltage (for instance 5 V) obtained from the motherboard 102 into a larger output current (for example 100 A) and a smaller output voltage (for example 0.85 V). Preferably, the high current output of the power converter module 104 may be supplied to the processor module 106 but not to the memory module 108. The memory module 108 may be operated with a lower current, for instance with the input current of the motherboard 102. The memory module 108 can include its own power supply (such as a PIMIC) and furthermore a memory controller as it may be used for DDR5 RAM. In another embodiment, also the memory module 108 may be supplied with the higher output current.

Advantageously, the heat sink 110 is configured for removing heat from the processor module 106 and from the memory module 108 along thermally separated heat removal paths so that the processor module 106 and the memory module 108 are thermally decoupled from each other. The processor module 106 may generate a high amount of heat during operation. Although the amount of heat generated by the memory module 108 may be smaller, also the memory module 108 should be cooled by thermally connecting it to the heat sink 110. Furthermore, the memory module 108 may be very sensitive with respect to overheating. For instance, a memory module 108 of a specific type may not be heated above 85°C. In order to ensure proper cooling of the processor module 106 and the memory module 108 by the same heat sink 110 and thus in a compact way, a gap 182 may be formed as an interruption in the heat spreader layer 128 (and/or in the thermal coupling layer 126 and/or in the heat sink 110, not shown) for thermally decoupling the heat removal paths of the processor module 106 and the memory module 108. Thus, the metallic heat spreader layer 128 is interrupted laterally between the processor module 106 and the memory module 108. Consequently, an undesired lateral heat flow from the processor module 106 to the memory module 100 may be strongly suppressed.

According to Figure 1, electrically conductive high-speed lines may extend along an upper portion of the motherboard 102. Furthermore, both the processor module 106 and the memory module 108 may be connected with one or more power supply terminals of the power converter module 104.

The embodiment of Figure 1 corresponds to a side by side arrangement of the processor module 106 and the memory module 108. Furthermore, the electronic device 100 of Figure 1 is configured for single sided cooling and is optimized for an efficient power supply.

**Figure 2** illustrates a cross-sectional view of an electronic device 100 according to another exemplary embodiment of the invention.

The embodiment of Figure 2 differs from the embodiment of Figure 1 in particular in that, according to Figure 2, the power converter module 104 is arranged vertically in between, on the one hand, the bottom-sided motherboard 102 and, on the other hand, the processor module 106 and the memory module 108 on the top side of the power converter module 104. Hence, the heat removal paths from the processor module 106 and from the memory module 108 to the heat sink 110 are very short according to Figure 2. As shown in Figure 2 as well, the processor module 106 and the memory module 108 are mounted side-by-side on the power converter module 104.

Furthermore, the power converter module 104 of Figure 2 comprises a bottom-sided lower density connection region 140 coupled with the motherboard 102 and a top-sided higher density connection region 142 coupled with the processor module 106 and the memory module 108. Correspondingly, the power converter module 104 comprises a redistribution structure 144 between the bottom-sided lower density connection region 140 and the top-sided higher density connection region 142 which provides a transition in terms of density of wiring elements. The lower density connection region 140 and the higher density connection region 142 may be embodied as two different boards, or as one inhomogeneous common board. While the bottom-sided lower density connection region 140 is configured for power conversion (and may be compatible with an electric power of at least 80 W, in particular at least 100 W), the top-sided higher density connection region 142 is configured for signal supply to the processor module 106 and the memory module 108. The described design of the power converter module 104 promotes a flat design with small space consumption in a vertical direction and nevertheless combines the functionality of high density signal supply with the capability to supply high electric power. The higher density connection region 142 may also provide a fan-out function.

The electronic device 100 of Figure 2 furthermore comprises a vertically extending thermal coupling arrangement 146 laterally bypassing the processor module 106 and the memory module 108 for thermally coupling the power converter module 104 with the heat sink 110 without processor module 106 and memory module 108 in between. In the shown embodiment, the vertically extending thermal coupling arrangement 146 is embodied as a set of two metal pillars (in particular copper pillars). As shown, the vertically extending thermal coupling arrangement 146 thermally connects the upper main surface of the power converter module 104 with the thermal coupling layer 126 directly beneath the heat sink 110. This allows to efficiently dissipate heat from the power converter module 104 to the heat sink 110 despite of the large vertical spacing in between. Additionally or alternatively, the vertically extending thermal coupling arrangement 146 may provide mechanical stability to the electronic device 100.

Additionally or alternatively, the embodiment of Figure 2 may have an embedded thermal coupling arrangement 148 in the motherboard 102 for removing heat from the power converter module 104 through the motherboard 102. For example, the thermal coupling arrangement 148 may be embodied as a set of metal pillars (in particular copper pillars) embedded as inlays in the motherboard 102. The thermal coupling arrangement 148 integrated in the motherboard 102 may be an appropriate solution in which double-sided cooling is allowed by a specific design. If a design rule for the electronic device 100 requires single sided cooling, the thermal coupling arrangement 148 may be omitted, and heat removal away from the power converter module 104 may be accomplished solely by the thermal coupling arrangement 146.

Also the embodiment of Figure 2 relies on a side by side arrangement of the processor module 106 and the memory module 108 and is configured for single side cooling (unless the optional thermal coupling arrangement 148 is foreseen).

The embodiment of Figure 2 is optimized for cooling, i.e. may provide a high thermal performance.

**Figure 3** illustrates a cross-sectional view of an electronic device 100 according to a preferred embodiment of the invention.

The embodiment of Figure 3 differs from the embodiment of Figure 2 in particular in that, according to Figure 3, the processor module 106 and the memory module 108 being mounted side-by-side on the power converter module 104 are embedded in a common plate-shaped board 116. For example, the plate-shaped board 116 may be manufactured separately and may then be connected to the power converter module 104. It is however also possible that the power converter module 104 is manufactured, die components are assembled, underfilled, overmolded, flushed with chip, and copper plated on the top side. The plate-shaped board 116 may be a laminate-type component carrier or may comprise a mold-type encapsulant. This design contributes to a compact configuration in vertical direction. Advantageously, a DC-DC converter of the power converter module 104 may be spatially close to the processor module 108 in the embodiment of Figure 3.

Also the side by side arrangement of Figure 3 is configured for single side cooling. Furthermore, this embodiment is optimized for supply chain. That means that the used dies are designed to use them for microball assembly. This is the way how they may be used to make flip chip BGA packages. The package architecture of the electronic device 100 according to Figure 3 contains a power supply being provided directly to the dies of the processor module 106 and the memory module 108. The power supply is directly coupled to said components.

Due to the small vertical distance between the power converter module 104 and the (for instance plated) heat spreader layer 128, heat removal from the power converter module 104 is sufficient, even when omitting thermal coupling arrangement 146 and/or 148 (which may nevertheless be present in yet another alternative to Figure 3). For instance, the heat spreader layer 128 may be formed by sputtering or by a chemical deposition process.

**Figure 4** illustrates a cross-sectional view of an electronic device 100 according to still another exemplary embodiment of the invention.

The embodiment of Figure 4 differs from the previously described embodiments in particular in that, according to Figure 4, the processor module 106 and the memory module 108 are vertically stacked above each other. More specifically, the processor module 106 is mounted above the memory module 108 according to Figure 4. As shown, the processor module 106 and the memory module 108 are accommodated in a common cavity 118 in an interior of the power converter module 104. In this embodiment, the cavity 118 has a narrower lower section shaped and dimensioned for accommodating the memory module 108 and a wider upper section shaped and dimensioned for accommodating the processor module 106. This single stepped cavity design is appropriate and allows a simple manufacture, since the processor module 106 has a larger lateral extension than the memory module 108.

According to Figure 4, heat removal from the thermally most critical processor module 106 is efficiently enabled through heat spreader layer 128 and thermal coupling layer 126 to heat sink 110. In order to further promote heat removal from the bottom-sided memory module 108, the electronic device 100 of Figure 4 comprises a thermal bypass structure 124 thermally coupling the memory module 108 with the heat sink 110 and extending laterally around the upper processor module 106. More specifically, the thermal bypass structure 124 comprises a bottom-sided metal sheet 184 (such as a clip) being thermally coupled (for example through a further thermal coupling layer 126 and through a further heat spreader layer 128) with the memory module 108. Horizontal sheet 184 is thermally coupled by a thermally conductive solder structure 186 to thermal vias 188 extending to heat spreader layer 128 and thermal coupling layer 126 at the bottom of the heat sink 110.

While said thermal vias 188 function for cooling the memory module 108, thermal vias 192 function for cooling the power converter module 104.

In the embodiment of Figure 4, the processor module 106 is located with a very small distance to the memory module 108 and with a very small distance to the heat sink 110. This combines low signal losses, high signal quality and high thermal performance.

Also the architecture according to Figure 4 enables single sided cooling. The embodiment of Figure 4 is optimized for interconnection and power. Just as an example, the size of the power module may be 80 mm x 80 mm. According to Figure 4, the processor may also be embedded in a substrate with direct heat routing upwards.

**Figure 5** illustrates a cross-sectional view of an electronic device 100 according to still another exemplary embodiment of the invention.

The embodiment of Figure 5 differs from the embodiment of Figure 4 in particular in that, according to Figure 5, only the memory module 108, not the processor module 106, is embedded in a cavity 118 of the power converter module 104. The processor semiconductor chip 170 of the processor module 106 is embedded in a separate board 190, which may be a substrate or a printed circuit board.

An exemplary and schematic current flow path from the motherboard 102 through the power converter module 104 into the processor module 106 and the memory module 108 is indicated with arrows in Figure 5.

The embodiment of Figure 5 is also configured for single sided cooling, and is optimized for interconnection and power. According to Figure 5, a connection may be made directly via a redistribution layer location. A separate heat dissipation path may be created for the memory module 108.

**Figure 6** illustrates a vehicle 200 (such as a car) comprising an electronic device 100 (for instance configured as one of the embodiments shown in Figure 1 to Figure 5) according to an exemplary embodiment of the invention. For example, the electronic device 100 may function in the vehicle 200 as a controller for autonomous driving.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. An electronic device (100) which comprises:
a motherboard (102);
a power converter module (104);
a processor module (106);
a memory module (108); and
a heat sink (110);
wherein at least one of the power converter module (104), the processor module (106) and the memory module (108) is mounted on the motherboard (102) for signal transmission and electric power supply;
wherein the heat sink (110) is thermally coupled at least with the processor module (106) and the memory module (108) for removing heat; and
wherein the power converter module (104), the processor module (106) and the memory module (108) are arranged between the motherboard (102) and the heat sink (110).

2. The electronic device (100) according to claim 1, wherein the motherboard (102) is connected for transmitting signals to the processor module (106) and the memory module (108) and electric power to the power converter module (104).

3. The electronic device (100) according to claim 1 to 2, wherein the power converter module (104) is configured for converting an input current and an input voltage into a larger output current and a smaller output voltage.

4. The electronic device (100) according to any of claims 1 to 3, wherein the heat sink (110) is configured for removing heat from the processor module (106) and from the memory module (108) along thermally separated heat removal paths so that the processor module (106) and the memory module (108) are thermally decoupled from each other.

5. The electronic device (100) according to any of claims 1 to 4, wherein the processor module (106) and the memory module (108) are mounted side-by-side on the motherboard (102) or on the power converter module (104), in particular embedded in a common plate-shaped board (116).

6. The electronic device (100) according to any of claims 1 to 5, wherein the processor module (106) and the memory module (108) are vertically stacked above each other.

7. The electronic device (100) according to claim 6, wherein the processor module (106) is mounted above the memory module (108).

8. The electronic device (100) according to claim 6 or 7, wherein the processor module (106) and the memory module (108) are accommodated in a cavity (118) in an interior of the electronic device (100).

9. The electronic device (100) according to claim 8, wherein the cavity (118) has a narrower section and a wider section for accommodating the processor module (106) and the memory module (108) having different lateral extensions.

10. The electronic device (100) according to any of claims 6 to 9, comprising a thermal bypass structure (124) thermally coupling the lower one of the processor module (106) and the memory module (108) with the heat sink (110) and extending around the upper one of the processor module (106) and the memory module (108).

11. The electronic device (100) according to any of claims 1 to 10, wherein the power converter module (104) is arranged vertically in between, on the one hand, the processor module (106) and the memory module (108) and, on the other hand, the heat sink (110).

12. The electronic device (100) according to any of claims 1 to 11, wherein the power converter module (104) is arranged vertically in between, on the one hand, the motherboard (102) and, on the other hand, the processor module (106) and the memory module (108).

13. The electronic device (100) according to any of claims 1 to 12, wherein the power converter module (104) comprises a bottom-sided lower density connection region (140) coupled with the motherboard (102) and a top-sided higher density connection region (142) coupled with the processor module (106) and the memory module (108).

14. A vehicle (200), comprising an electronic device (100) according to any of claims 1 to 13.

15. A method of manufacturing an electronic device (100), wherein the method comprises:
connecting a motherboard (102), a power converter module (104), a processor module (106), a memory module (108), and a heat sink (110);
mounting at least one of the power converter module (104), the processor module (106) and the memory module (108) on the motherboard (102) for signal transmission and electric power supply;
thermally coupling the heat sink (110) at least with the processor module (106) and the memory module (108) for removing heat; and
arranging the power converter module (104), the processor module (106) and the memory module (108) between the motherboard (102) and the heat sink (110).
